# DEMANDE DE BREVET EUROPEEN

(11) **EP 1 213 762 A1**
(43) Date de publication de la demande: **12.06.2002**
(21) Numéro de dépôt: 01204606.6
(22) Date de dépôt: 29.11.2001
(51) Int. Cl.: H01L 27/08, H01L 21/02, H01L 23/64, H01L 23/522, H01L 21/762

(54) **Dispositif d'isolation d'un élement électrique**

(30) Priorité: 05.12.2000 FR 0015750
(71) Demandeur: Koninklijke Philips Electronics N.V., 5621 BA Eindhoven (NL)
(72) Inventeur: Butaye, Benoît, c/o Société Civile S.P.I.D., 75008 Paris (FR); Gamand, Patrice, c/o Société Civile S.P.I.D., 75008 Paris (FR)
(74) Mandataire: Chaffraix, Jean

(57) **Abrégé**

L'invention concerne un dispositif d'isolation (10) destiné à empêcher la propagation d'un rayonnement électromagnétique produit par au moins un élément électrique intégré à un substrat faiblement résistif (11), ledit dispositif d'isolation (10) étant robuste et présentant des propriétés d'isolation uniformes dans l'espace.

Un dispositif d'isolation (10) suivant l'invention inclut une pluralité de tranches d'isolation (12) s'étendant dans le substrat et substantiellement parallèles entre elles, et une pluralité de séries de traverses d'isolation (13) de profondeur voisine de celle desdites tranches d'isolation, lesdites tranches (12) et lesdites séries de traverses (13) contenant un matériau résistif de résistivité supérieure à la résistivité du substrat, chaque série de traverses étant réalisée transversalement entre deux tranches d'isolation adjacentes et agencée de sorte que deux traverses incluses dans deux séries adjacentes ne sont pas dans le prolongement l'une de l'autre.

## Description

L'invention concerne un dispositif d'isolation destiné à empêcher la propagation d'un rayonnement électromagnétique produit par au moins un élément électrique intégré à un substrat faiblement résistif, ledit dispositif d'isolation incluant une pluralité de tranches d'isolation s'étendant dans le substrat et substantiellement parallèles entre elles, lesdites tranches contenant un matériau résistif de résistivité supérieure à la résistivité du substrat.

L'invention concerne également un circuit intégré incluant un tel dispositif d'isolation. Plus particulièrement, le dispositif d'isolation peut avantageusement être mis en oeuvre dans un circuit intégré incluant des éléments passifs soumis à des courants de haute fréquence comme, par exemple, un élément inductif, une capacité, une plage de connexion, un plot d'entrée-sortie, les propriétés de tels éléments passifs étant dépendantes de leur isolation électromagnétique.

Le document EP 0 966 040 A1 présente un circuit intégré incluant un tel dispositif d'isolation. Le dispositif d'isolation décrit dans ce document inclut, dans un premier mode de réalisation, une série de tranches d'isolation parallèles entre elles et espacées selon une unique direction, remplies d'un matériau de résistivité supérieure à la résistivité du substrat. Ce mode de réalisation correspond au dispositif d'isolation du paragraphe introductif.

Un tel dispositif d'isolation permet d'augmenter localement la résistance du substrat et de diminuer l'influence des phénomènes capacitifs entre l'élément électrique intégré et le substrat. Ces deux effets entraînent une isolation électromagnétique de l'élément électrique qui permet d'obtenir un fonctionnement dudit élément de meilleure qualité que lorsque ledit élément est intégré directement sur le substrat faiblement résistif.

Ce premier mode de réalisation a pour inconvénient de ne permettre qu'une isolation limitée car la résistance du substrat est augmentée uniquement sur une surface délimitée par des tranches parallèles. Dans un mode de réalisation plus performant également exposé dans le document EP 0 966 040 A1, des tranches d'isolation s'étendent dans le substrat selon un motif en croix formé par des tranches d'isolation parallèles entre elles et espacées selon une première direction et des tranches d'isolation parallèles entre elles et espacées selon une seconde direction, perpendiculaire à la première direction. La résistance du substrat est ainsi augmentée sur la presque totalité de sa surface, seuls des piliers de substrat présents entre les tranches présentant une faible résistivité.

L'invention est liée aux considérations suivantes :
Le dispositif d'isolation connu est réalisé suivant un motif en croix, du fait duquel les tranches suivant les deux directions perpendiculaires délimitent des piliers de substrat substantiellement alignés selon les deux directions des tranches. Chaque intersection entre des tranches suivant deux directions perpendiculaires délimite ainsi quatre piliers de substrat. Dans l'état actuel de la technique, les conditions de gravure d'un tel motif sont telles que la forme des coins des piliers de substrat n'est pas reproductible d'une intersection à l'autre. Ainsi, les piliers sont tous différents et ne sont pas des parallélépipèdes parfaits. Par conséquent, lorsque les tranches sont remplies de matériau de résistivité supérieure à celle du substrat, les piliers subissent des contraintes dissymétriques qui peuvent les faire pencher lors du remplissage desdites tranches et par la suite. Par exemple, lors du fonctionnement du circuit, des contraintes thermiques combinées à la dissymétrie des piliers provoquent souvent une déformation des piliers de substrat. Ces problèmes physiques influent sur les propriétés de l'isolation conférée par le dispositif d'isolation. Ainsi, ledit dispositif possède des propriétés non uniformes dans l'espace et dans le temps.
Un but de l'invention est de fournir un dispositif d'isolation robuste et présentant des propriétés d'isolation uniformes dans l'espace.

En effet, un dispositif d'isolation conforme au paragraphe introductif est remarquable selon l'invention en ce qu'il inclut une pluralité de séries de traverses d'isolation de profondeur voisine de celle desdites tranches d'isolation, et contenant un matériau résistif de résistivité supérieure à la résistivité du substrat, chaque série étant réalisée transversalement entre deux tranches d'isolation adjacentes et agencée de sorte que deux traverses incluses dans deux séries adjacentes ne sont pas dans le prolongement l'une de l'autre.

Dans le dispositif d'isolation, les piliers de substrat sont substantiellement alignés suivant une direction et décalés en'quinconce' suivant une seconde direction. Chaque intersection entre une tranche et une traverse délimite trois piliers de substrat. Cette géométrie reproduisant un motif similaire à celui d'un empilement de briques dans un mur permet une meilleure tenue des piliers de substrat et par conséquent une bonne uniformité dans l'espace ainsi qu'une bonne robustesse dans le temps du dispositif d'isolation. L'invention est utile dans le cadre de l'isolation d'éléments électriques qui ont un fonctionnement dont la qualité est dépendante de pertes suivant une direction perpendiculaire au plan de l'élément. Lesdites pertes se produisent du fait de capacités et de résistances parasites dans les couches sous- et/ou sur-jacentes à l'élément. De telles grandeurs parasites sont modifiées dans le sens de la diminution des pertes par les caractéristiques du substrat modifié. Ces modifications sont similaires à celles obtenues dans l'art antérieur.

Cependant, avec certains éléments comme les éléments passifs, des courants radiaux parallèles au plan de l'élément peuvent se développer lors du fonctionnement dudit élément. Ces courants occasionnent des pertes d'énergie par effet Joule dès lors que le milieu est résistif. Un but de l'invention est de réduire ces pertes d'énergie en court-circuitant lesdits courants radiaux.

En effet, un dispositif d'isolation selon un mode avantageux de réalisation de l'invention, est remarquable en ce qu'il inclut une couche conductrice disposée entre l'élément électrique et le substrat, et des moyens pour isoler ladite couche conductrice dudit élément.

Dans ce dispositif d'isolation, les courants radiaux apparaissant pendant le fonctionnement de l'élément électrique se concentrent dans la couche conductrice où ils sont localisés. Les pertes d'énergie sont minimisées car ces courants circulent dans un milieu peu résistif et ces courants peuvent être évacués, par exemple, par connexion de la couche conductrice à une masse du circuit.

Dans le cas d'un élément électrique inductif, généralement constitué d'une spirale métallique, un phénomène supplémentaire se produit : un courant circumférentiel est induit dans les couches sous- et/ou sur-jacentes à la spirale métallique. Ceci est sensible lorsque le substrat est faiblement résistif. La qualité du fonctionnement de l'élément inductif est généralement modélisée par la valeur d'un facteur de qualité calculé à partir de caractéristiques propres à l'élément inductif et à son environnement. La présence du courant circumférentiel influe de deux manières sur le facteur de qualité de l'élément inductif :
par des pertes résistives induites par ces courants circulant dans des milieux résistifs ;
par des couplages mutuels selon lesquels un courant circumférentiel induit dans une couche induit, à son tour, un champ magnétique s'opposant à celui qui l'a créé, c'est-à-dire celui de la spirale métallique. Le champ magnétique induit provoque une diminution de l'inductance de l'élément inductif.

L'augmentation de résistance du substrat permet de limiter l'amplitude de ces courants induits mais augmente les pertes résistives tandis que la présence d'une couche conductrice diminue les pertes résistives mais augmente la valeur du champ magnétique induit.

Un mode de réalisation particulièrement avantageux de l'invention permet de limiter l'amplitude de ces courants circumférentiels induits sans augmenter les pertes résistives en proposant un dispositif d'isolation qui inclut une couche conductrice formant un circuit ouvert.

Un tel circuit ouvert limite le développement des courants circumférentiels qui sont des courants en boucle. La couche conductrice peut en particulier être constituée de segments conducteurs qui minimisent les courants circumférentiels induits par le champ magnétique de l'élément inductif dans la couche conductrice en empêchant leur extension sur d'importantes surfaces, tout en court-circuitant les courants qui circuleraient dans un milieu plus résistif sous- et/ou sur-jacent en l'absence de cette couche conductrice. Les segments conducteurs peuvent être connectés à un cadre non fermé. L'ensemble fonctionne alors comme un circuit ouvert vis-à-vis des courants qui pourraient y être induits.

Plus généralement, la présente invention peut être mise en oeuvre dans tout circuit incluant un élément électrique ou électronique qui est avantageusement isolé du substrat. Le circuit intégré peut être par exemple un oscillateur, un mélangeur à charge active ou un filtre. Dans une de ses applications, l'invention concerne donc également un oscillateur destiné à délivrer un signal de sortie ayant une fréquence dont la valeur dépend de la valeur d'une tension de réglage, caractérisé en ce qu'il est réalisé sous la forme d'un circuit intégré tel que décrit plus haut, incluant, en outre, au moins une diode de type varicap, reliée à l'élément inductif et destinée à être polarisée au moyen de la tension de réglage.

Plus généralement, la présente invention peut être avantageusement mise en oeuvre dans un appareil récepteur de signaux radioélectriques.

L'invention sera mieux comprise à la lumière de la description suivante de quelques modes de réalisation, faite à titre d'exemple et en regard des dessins annexés, dans lesquels :
- la figure 1 est une vue de dessus d'un dispositif d'isolation conforme à l'invention sans l'élément électrique ou électronique intégré,
- la figure 2 est une section représentant un circuit intégré conforme à un mode de réalisation avantageux de l'invention,
- la figure 3 est une vue de dessus d'une couche conductrice utilisée dans un dispositif d'isolation d'un élément inductif,
- la figure 4 est une vue de dessus de deux éléments inductifs présents dans un circuit selon une variante de l'invention,
- la figure 5 est un schéma fonctionnel d'un oscillateur conforme à un mode de mise en oeuvre particulier de l'invention, et
- la figure 6 est un schéma fonctionnel d'un appareil récepteur de signaux radioélectriques comprenant un tel oscillateur.

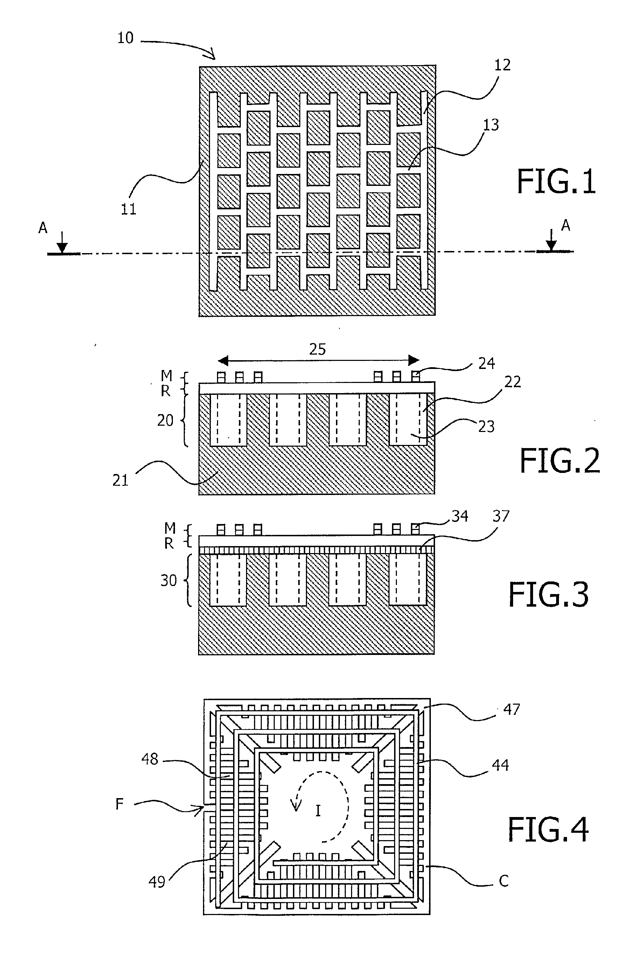

La figure 1 est une vue de dessus d'un dispositif d'isolation 10 selon l'invention solidaire d'un substrat 11. Ledit dispositif d'isolation inclut une pluralité de tranches d'isolation 12 substantiellement parallèles entre elles et une pluralité de séries de traverses d'isolation 13, chaque série étant réalisée transversalement entre deux tranches d'isolation adjacentes et agencées de sorte que deux traverses incluses dans deux séries adjacentes ne sont pas dans le prolongement l'une de l'autre. Cette géométrie particulière permet un bon maintien en position des piliers de substrat et par conséquent une substantielle uniformité dans l'espace des propriétés du dispositif d'isolation ainsi qu'une bonne robustesse dans le temps. Les tranches et les séries de traverses sont remplies d'un matériau de résistivité supérieure à celle du substrat 11, voire d'une combinaison de plusieurs matériaux. L'ensemble constitué par les tranches et les séries de traverses forme une grille résistive d'isolation. Cette grille d'isolation remplace le volume de substrat au niveau des tranches et des traverses, le facteur de recouvrement en surface de cette grille varie suivant les propriétés requises pour le dispositif d'isolation. La fabrication d'un dispositif d'isolation selon l'invention met en oeuvre des procédés permettant de creuser le substrat ou d'implanter des ions dans certaines régions de ce substrat, ces procédés utilisant classiquement des masques dans le but d'obtenir la géométrie du dispositif d'isolation revendiqué.

La figure 2 est une section, suivant un plan de section AA représenté sur la figure précédente, d'un circuit intégré incluant un dispositif d'isolation 20 selon l'invention. Le dispositif d'isolation 20 est, à titre d'exemple, ici destiné à isoler un élément inductif 24 superposé au substrat 21. Cet élément inductif 24 est, par exemple, constitué d'une spirale métallique réalisée dans une couche métallique M et délimitant par son contour extérieur une surface dite surface d'isolation 25, ici représentée sur une dimension. Avantageusement, le dispositif d'isolation a une surface substantiellement identique à la surface d'isolation. Les tranches d'isolation 22 sont représentées sur la figure 2 par des pointillés car elles ne sont pas dans le plan de section. Les traverses 23 présentes dans le plan de section appartiennent à une série sur deux et sont, dans cet exemple, dans le prolongement l'une de l'autre ainsi que représenté sur la figure 1. Les tranches et les séries de traverses ont des profondeurs substantiellement identiques et sont remplies d'un matériau de résistivité supérieure à celle du substrat. La profondeur des tranches, leur largeur et le rapport entre ces deux grandeurs sont indifférents au problème résolu par l'invention. Le choix de ces grandeurs dépend des propriétés qui sont requises pour le dispositif d'isolation. Une couche R constituée de matériau isolant est présente entre le dispositif d'isolation 20 et l'élément électrique 24 réalisé dans la couche M.

L'invention est utile dans le cadre de l'isolation d'éléments électriques qui présentent un fonctionnement dont la qualité dépend de pertes suivant une direction perpendiculaire au plan de l'élément. Lesdites pertes sont générées par des capacités et des résistances parasites dans les couches sous- et/ou sur-jacentes à l'élément. En l'absence de dispositif d'isolation, la capacité parasite globale entre le substrat et l'élément électrique est importante. En présence de la grille d'isolation, la capacité parasite globale est diminuée car les capacités locales entre la grille et la couche isolante sont faibles ; d'autres capacités parasites sont, dans ce cas, constituées par la capacité propre de la grille, qui est faible, et par la capacité parasite entre le substrat et le matériau résistant remplissant les tranches et traverses. La capacité globale résultante est alors notablement plus faible qu'en l'absence de la grille. Ceci contribue à améliorer la qualité du fonctionnement de l'élément électrique.

Un autre phénomène parasite concerne les courants radiaux circulant dans un plan parallèle au plan de l'élément, et donc dans le substrat en l'absence de dispositif isolant. Ces courants génèrent des pertes par effet Joule. En présence de la grille d'isolation, ces courants circulent toujours dans le substrat sous ladite grille. Cependant, ces courants sont limités en intensité par la présence de la résistance élevée du matériau résistif remplissant les couches, résistance que lesdits courants doivent traverser avant de circuler dans le substrat.

La figure 3 présente un mode réalisation avantageux de l'invention, dans lequel ces courants parasites radiaux sont court-circuités grâce à une combinaison de la grille résistive 30 avec une couche conductrice 37 placée entre l'élément électrique 34 et la grille 30. Une couche isolante R est placée entre l'élément électrique 34 et la couche conductrice 37. Les courants radiaux circulent préférentiellement dans la couche conductrice plutôt que dans le substrat qui est rendu résistif par la grille. Dans le cas où les courants qui sont induits par la présence de l'élément électrique sont faibles, les pertes par effet Joule sont alors fortement diminuées. La couche conductrice peut, par exemple, être connectée à la masse de manière à évacuer ces courants.

Dans un mode particulier de mise en oeuvre de l'invention déjà évoquée, l'élément électrique est un élément inductif. Le phénomène d'induction génère des courant radiaux importants dans les couches sous- et/ou sur-jacentes à l'élément inductif. En présence d'une couche conductrice recouvrant la totalité de la surface d'isolation, les courants radiaux circumférentiels induits se développent fortement dans ladite couche conductrice. En plus de l'effet Joule ainsi généré, le fonctionnement de l'élément inductif est affecté par le couplage inductif qui entraîne une diminution de l'inductance effective de l'élément inductif. Dans un cas pareil, la couche conductrice formera donc avantageusement un circuit ouvert pour les courants induits par l'élément électrique dans cette couche.

La figure 4 montre un exemple particulier de couche conductrice 47 formant un circuit ouvert pour les courants induits. Ladite couche est représentée avec un élément inductif 44 superposé à ladite couche conductrice 47. Ici, l'élément inductif est constitué par une spire métallique présentant un contour extérieur et un contour intérieur délimitant entre eux une surface dite de rayonnement. Dans cet exemple, la surface de la couche conductrice 47 est substantiellement identique à la surface de rayonnement de l'élément inductif 44. Cette couche conductrice 47 est réalisée en matériau faiblement résistif ou conducteur et placée perpendiculairement aux vecteurs du champ magnétique développé par l'élément inductif 44. Elle peut comporter, ainsi que représenté, une alternance de bandes 48 et de fentes 49. Les bandes 48, qui constituent des segments conducteurs, peuvent, par exemple, être réalisées en un alliage métallique ou en polysilicium. La couche conductrice étant disposée perpendiculairement aux vecteurs du champ magnétique développé par l'élément inductif, un courant induit I pourrait apparaître dans la plaque si celle-ci était réalisée d'une seule pièce. L'alternance de fentes 49 et de bandes 48 disposées perpendiculairement à ce courant I forme un circuit ouvert empêchant la circulation d'un tel courant induit. Ce courant étant ainsi presque nul dans la couche conductrice, la mutuelle inductance qui peut apparaître entre ladite couche et l'élément inductif est, elle aussi, presque nulle et n'altère pas de manière significative le facteur de qualité de l'élément inductif. Les bandes sont connectées à l'extérieur sur un cadre C non fermé. Une fente F sur le cadre C empêche la formation d'une boucle de courant sur le cadre.

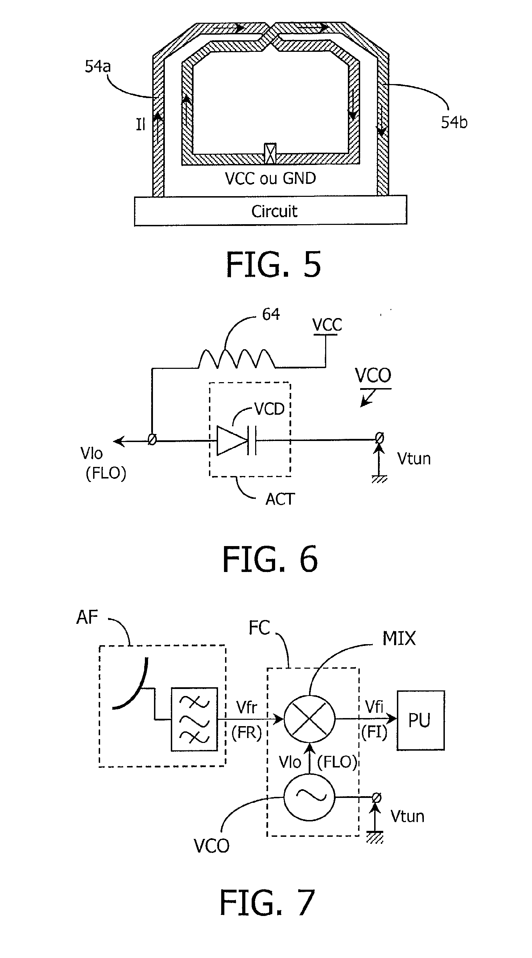

La figure 5 est une vue de dessus de deux éléments inductifs inclus dans un circuit intégré conforme à une variante de l'invention. Le circuit présenté est composé d'une seule spire. Cette spire inclut deux éléments inductifs 54a et 54b, hachurés différemment sur la figure. Ces deux éléments inductifs sont symétriques et imbriqués l'un dans l'autre. Ils sont tous deux connectés entre une borne de potentiel, qui peut être, suivant l'application à laquelle le circuit est destiné, soit une borne d'alimentation VCC de potentiel fixe ou variable, soit une borne de potentiel de référence ou masse GND, et une borne reliant l'élément inductif 54a ou 54b à un sous-circuit et destinés à être parcourus par un courant Il circulant entre lesdites bornes. Dans ces deux éléments inductifs, le courant circule dans le même sens à chaque instant, ceci conformément aux flèches représentées sur la figure 5. La mutuelle inductance entre deux pistes conductrices voisines et parallèles est dépendante du sens de parcours de l'intensité. Lorsque les sens de parcours de l'intensité sont opposés, la mutuelle inductance se soustrait à l'inductance propre de chaque piste. Lorsque les sens de parcours sont identiques, la mutuelle inductance s'ajoute à l'inductance propre de chaque piste. Dans la structure proposée ici, les parties de spires voisines sont parcourues par des courants de sens identique : on augmente ainsi les inductances des deux éléments inductifs et leurs facteurs de qualité. Par conséquent, on augmente les performances du circuit. En application de l'invention, un dispositif d'isolation conforme à un de ceux représentés par les différentes figures précédentes est avantageusement superposé à la spire constituant les éléments inductifs 54a et 54b. Ces deux éléments inductifs présentent ainsi des facteurs de qualité élevés.

La figure 6 est un schéma fonctionnel d'un oscillateur VCO réalisé sous la forme d'un circuit intégré conforme à l'invention. Cet oscillateur VCO est destiné à fournir un signal de tension Vlo ayant une fréquence FLO dont la valeur dépend de celle d'une tension de réglage Vtun. Cet oscillateur comprend un élément inductif 64 isolé par un dispositif selon l'invention, connecté à une borne d'alimentation VCC, et une zone active ACT, comportant une diode de type varicap VCD destinée à être polarisée au moyen de la tension de réglage Vtun. Comme la diode varicap VCD présente une capacité variable en fonction de la valeur de sa tension de polarisation, la fréquence de résonance du circuit L-C est elle aussi variable. La présence du dispositif d'isolation de l'élément inductif empêche la propagation d'un rayonnement électromagnétique vers la zone active ACT.

La figure 7 représente schématiquement un appareil récepteur de signaux radioélectriques, par exemple, un radiotéléphone, un téléviseur ou un boîtier-décodeur comportant un étage d'entrée AF, constitué dans cet exemple d'un système d'antenne et de filtrage, permettant la réception d'un signal radioélectrique dont la fréquence FR, dite fréquence radio, est sélectionnée au sein d'une gamme de fréquences donnée, et sa transformation en un signal électronique Vfr dit signal radio. Cet appareil récepteur comporte en outre un convertisseur de fréquence FC, comprenant un oscillateur local VCO et un mélangeur MIX, lequel est destiné à recevoir le signal radio Vfr et un signal Vlo provenant de l'oscillateur local VCO dont la fréquence FLO, dite d'oscillation, est réglable, et à délivrer un signal de sortie Vfi ayant une fréquence intermédiaire FI fixée et égale à la différence entre la fréquence radio FR et la fréquence d'oscillation FLO.

Dans ce convertisseur de fréquence FC, le choix de la valeur de la fréquence d'oscillation FLO, effectué au moyen d'une tension de réglage Vtun, impose la valeur de la fréquence radio FR, puisque la fréquence intermédiaire FI est rendue fixe, par exemple à l'aide d'un système de filtrage, non représenté sur la figure, qui serait disposé en sortie du mélangeur MIX. Cet appareil récepteur comporte enfin une unité de traitement du signal PU destinée à exploiter le signal de sortie du mélangeur MIX.

L'invention permet d'obtenir une grande pureté spectrale pour le signal de sortie de l'oscillateur local VCO du fait du facteur de qualité élevé des éléments inductifs inclus dans ledit oscillateur. Cette pureté spectrale permet une sélection précise de la fréquence radio et, grâce à l'invention, n'est pas obtenue au prix d'un encombrement élevé de l'oscillateur local VCO.

## Revendications

1. Dispositif d'isolation destiné à empêcher la propagation d'un rayonnement électromagnétique produit par au moins un élément électrique intégré à un substrat faiblement résistif, ledit dispositif d'isolation incluant une pluralité de tranches d'isolation s'étendant dans le substrat et substantiellement parallèles entre elles, lesdites tranches contenant un matériau résistif de résistivité supérieure à la résistivité du substrat, **caractérisé en ce qu'**il inclut une pluralité de séries de traverses d'isolation de profondeur voisine de celle desdites tranches d'isolation, et contenant un matériau résistif de résistivité supérieure à la résistivité du substrat, chaque série étant réalisée transversalement entre deux tranches d'isolation adjacentes et agencée de sorte que deux traverses incluses dans deux séries adjacentes ne sont pas dans le prolongement l'une de l'autre.

2. Dispositif d'isolation selon la revendication 1, **caractérisé en ce que** l'élément électrique est un élément inductif présentant un contour extérieur délimitant une surface dite d'isolation et **en ce que** le dispositif d'isolation a une surface substantiellement identique à ladite surface d'isolation.

3. Dispositif d'isolation selon l'une des revendications 1 et 2, **caractérisé en ce qu'**il inclut une couche conductrice disposée entre l'élément électrique et le substrat, et des moyens pour isoler la couche conductrice de l'élément électrique.

4. Dispositif d'isolation selon la revendication 3, **caractérisé en ce que** la couche conductrice forme un circuit ouvert.

5. Dispositif d'isolation selon les revendications 3 et 4, **caractérisé en ce que**, l'élément inductif présentant un contour extérieur et un contour intérieur délimitant une surface dite de rayonnement, la couche conductrice possède une surface substantiellement identique à la surface de rayonnement.

6. Circuit intégré comprenant au moins un élément électrique intégré à un substrat faiblement résistif et isolé à l'aide d'un dispositif d'isolation selon l'une des revendications 1 à 5.

7. Oscillateur destiné à délivrer un signal de sortie ayant une fréquence dont la valeur dépend de la valeur d'une tension de réglage, lequel oscillateur inclut :
au moins un élément inductif,
au moins une diode de type varicap destinée à être polarisée au moyen de la tension de réglage,
un dispositif d'isolation conforme à la revendication 1.

8. Appareil récepteur de signaux radioélectriques, comportant :
. un étage d'entrée, permettant la réception d'un signal radioélectrique ayant une fréquence, dite fréquence radio, sélectionnée au sein d'une gamme de fréquences donnée, et sa transformation en un signal électronique dit signal radio,
. un oscillateur local ayant une fréquence, dite d'oscillation, réglable au moyen d'une tension de réglage, et
. un mélangeur, destiné à recevoir le signal radio et un signal provenant de l'oscillateur local et à délivrer un signal de sortie ayant une fréquence fixée et égale à la différence entre la fréquence radio et la fréquence d'oscillation, et
. une unité de traitement du signal destinée à exploiter le signal de sortie du mélangeur, appareil **caractérisé en ce que** l'oscillateur local est conforme à la revendication 7.
